# EUROPEAN PATENT APPLICATION

(11) **EP 4 811 952 A1**
(43) Date of publication of application: **23.09.2026**
(21) Application number: 25196677.6
(22) Date of filing: 19.08.2025
(51) Int. Cl.: H05K 9/00

(54) **ELECTROMAGNETIC SHIELDING MODULE AND PHOTOELECTRIC DEVICE**

(30) Priority: 17.03.2025 TW 114202607 U
(71) Applicant: Excellence Optoelectronics Inc., Chunan Town, Miaoli County 35053 (TW)
(72) Inventor: YANG, Sheng-Hua, 35053 Miaoli County, Hsinchu Science Park (TW); CHEN, Chien-Lung, 35053 Miaoli County, Hsinchu Science Park (TW); WANG, Ming-Ching, 35053 Miaoli County, Hsinchu Science Park (TW)
(74) Representative: Viering, Jentschura & Partner mbB Patent- und Rechtsanwälte

(57) **Abstract**

An electromagnetic shielding module (1) includes a cover (11) and a frame (12). The cover (11) has a first side wall (111) and a first snap structure (112). The first snap structure (112) is arranged on the first side wall (111), and the first snap structure (112) has a first slot (1121) and a first elastic arm (1122). The frame (12) has a second side wall (121) and a second snap structure (122). The second snap structure (122) is arranged on the second side wall (121). When the cover (11) and the frame (12) are combined, the first elastic arm (1122) and the second elastic arm (1222) overlap and engage with each other. A photoelectric device (Z) is further provided.

## Description

### FIELD OF THE DISCLOSURE

The present disclosure relates to a shielding structure, and more particularly to a shielding structure for preventing electromagnetic interference.

### BACKGROUND OF THE DISCLOSURE

With the advancement of technology, electronic products are becoming thinner and more compact. However, as the components in the electronic product become more sophisticated, electromagnetic interference (EMI) may become more serious. Conventionally, electronic products are often equipped with electromagnetic shielding structures to reduce electromagnetic interference, thereby meeting the user's requirements.

When designing for protection against electromagnetic interference, it is also necessary to consider properties such as radiation properties, conductivity properties, spectral distribution, interference suppression, compliance with standards, and anti-interference capabilities. Radiation properties are the electromagnetic radiation generated by the device during operation, and include radiation frequency, radiation intensity, and radiation pattern. Radiation properties can be used to determine the extent to which the device may interfere with its surroundings or other equipment. Conductivity properties are the conduction sensitivity of the device to an external electromagnetic field, the susceptibility of the device to the disturbing influence of the external electromagnetic field, and the degree of influence on the performance of device during operation. The spectral distribution is the frequency distribution of electromagnetic interference generated by the device. Understanding the spectral distribution of the device facilitates the determination of the frequency range of possible interference, so that appropriate suppression measures can be taken. The interference suppression is a technology or measure employed by the device to suppress the electromagnetic interference (e.g., filters, shielding materials, and grounding wire design), so as to reduce or eliminate interference to the equipment. The compliance with standards refers to the requirement for the device to comply with relevant EMI specifications. Ensuring that the device is compliant facilitates ensuring that the device complies with the standards and is acceptable in the marketplace. The anti-interference capabilities refer to the resistance of the device to external electromagnetic interference. The device with good interference resistance can operate stably in a complex electromagnetic environment without being easily affected by external interference.

In addition, existing electronic products or electric devices (e.g., vehicle lamps) may be used in a mobile environment. In addition to reducing the electromagnetic interference, the structure of the electromagnetic shielding structure should be designed to resist shaking or vibration to prevent the structure from disintegrating or loosening.

Therefore, how to improve the structural strength of the electromagnetic shielding structure through structural design improvement to overcome the abovementioned defects has become one of the important issues to be addressed in the related field.

### SUMMARY OF THE DISCLOSURE

In response to the above-referenced technical inadequacies, the present disclosure provides an electromagnetic shielding module, which includes a cover and a frame. The cover has a first side wall and a first snap structure. The first snap structure is arranged on the first side wall, and the first snap structure has a first slot and a first elastic arm. The first elastic arm is connected to a sideline of the first slot and extends out of a first inner wall surface. The frame is configured to be combined with the cover. The frame has a second side wall and a second snap structure. The second snap structure is arranged on the second side wall, and the second snap structure has a second slot and a second elastic arm. The second elastic arm is connected to a periphery of the second slot and extends out of a second inner wall surface. When the cover and the frame are forced to be brought closer to each other until the first snap structure and the second snap structure are combined, the first elastic arm and the second elastic arm overlap and engage with each other.

In one of the possible or preferred embodiments, the first elastic arm extends upward along a vertical direction, and the second elastic arm extends upward along the vertical direction.

In one of the possible or preferred embodiments, the frame further has a projection arranged on an outer wall of the second side wall. When the first snap structure is combined with the second snap structure, the projection is abutted against the first inner side wall surface.

In one of the possible or preferred embodiments, the cover further includes a top plate, and the top plate is provided with at least one through hole.

In one of the possible or preferred embodiments, the frame further has a top wall connected to a second side wall surface, and the top wall is provided with at least one opening.

In one of the possible or preferred embodiments, a material of each of the cover and the frame includes metal or alloy.

In one of the possible or preferred embodiments, each of the cover and the frame is made of tinplate, nickel silver, or galvanized steel.

In order to solve the above-mentioned problems, another one of the technical aspects adopted by the present disclosure is to provide a photoelectric device, which includes a circuit board and the electromagnetic shielding module.

One of the beneficial effects of the present disclosure is that, in the electromagnetic shielding module and the photoelectric device provided by the present disclosure, by virtue of "the cover having the first side wall and the first snap structure," "the first snap structure having the first slot and the first elastic arm, the first elastic arm being connected to the sideline of the first slot," "the frame having the second side wall and the second snap structure," "the second snap structure having the second slot and the second elastic arm, the second elastic arm being connected to the periphery of the second slot," and "when the cover and the frame are forced to be brought closer to each other until the first snap structure and the second snap structure are combined, the first elastic arm and the second elastic arm overlap and engage with each other," radiation properties, conductivity properties, spectral distribution, interference suppression, compliance with standards, and anti-interference capabilities of electromagnetic interference can be complied. In addition, the structural strength of the electromagnetic shielding module can be enhanced, improving the inadequacies of the existing technology.

These and other aspects of the present disclosure will become apparent from the following description of the embodiment taken in conjunction with the following drawings and their captions, although variations and modifications therein may be affected without departing from the spirit and scope of the novel concepts of the disclosure.

### BRIEF DESCRIPTION OF THE DRAWINGS

FIG. 1 is a schematic exploded view of an electromagnetic shielding module according to an embodiment of the present disclosure;
FIG. 2 is a schematic view showing an assembled status of the embodiment shown in FIG. 1;
FIG. 3 is a schematic cross-sectional view of the embodiment shown in FIG. 2;
FIG. 4 is a partial schematic enlarged view of the embodiment shown in FIG. 3;
FIG. 5 is a schematic cross-sectional view of the embodiment shown in FIG. 2;
FIG. 6 is a partial schematic enlarged view of the embodiment shown in FIG. 5;
FIG. 7 is a partial schematic view of a photoelectric device according to an embodiment of the present disclosure; and
FIG. 8 is a schematic view showing an assembled status of the embodiment shown in FIG. 7.

### DETAILED DESCRIPTION OF THE EXEMPLARY EMBODIMENTS

The present disclosure is more particularly described in the following examples that are intended as illustrative only since numerous modifications and variations therein will be apparent to those skilled in the art. Like numbers in the drawings indicate like components throughout the views. As used in the description herein and throughout the claims that follow, unless the context clearly dictates otherwise, the meaning of "a," "an" and "the" includes plural reference, and the meaning of "in" includes "in" and "on." Titles or subtitles can be used herein for the convenience of a reader, which shall have no influence on the scope of the present disclosure.

The terms used herein generally have their ordinary meanings in the art. In the case of conflict, the present document, including any definitions given herein, will prevail. The same thing can be expressed in more than one way. Alternative language and synonyms can be used for any term(s) discussed herein, and no special significance is to be placed upon whether a term is elaborated or discussed herein. A recital of one or more synonyms does not exclude the use of other synonyms. The use of examples anywhere in this specification including examples of any terms is illustrative only, and in no way limits the scope and meaning of the present disclosure or of any exemplified term. Likewise, the present disclosure is not limited to various embodiments given herein. Numbering terms such as "first," "second" or "third" can be used to describe various components, signals or the like, which are for distinguishing one component/signal from another one only, and are not intended to, nor should be construed to impose any substantive limitations on the components, signals or the like.

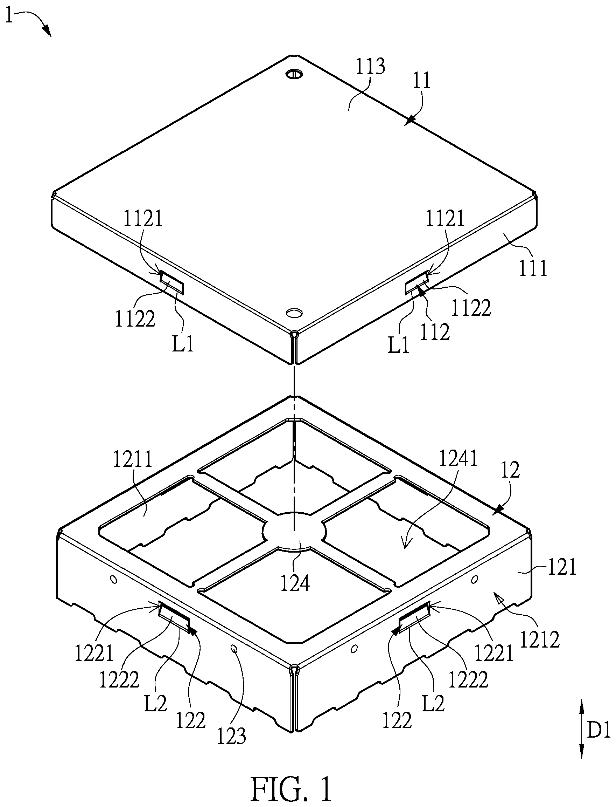

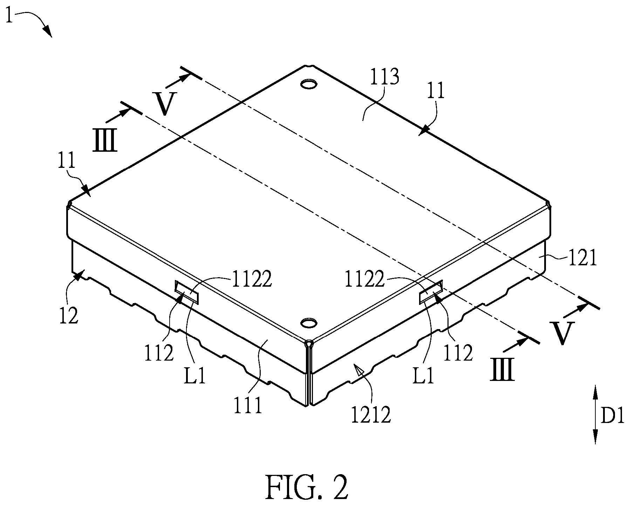

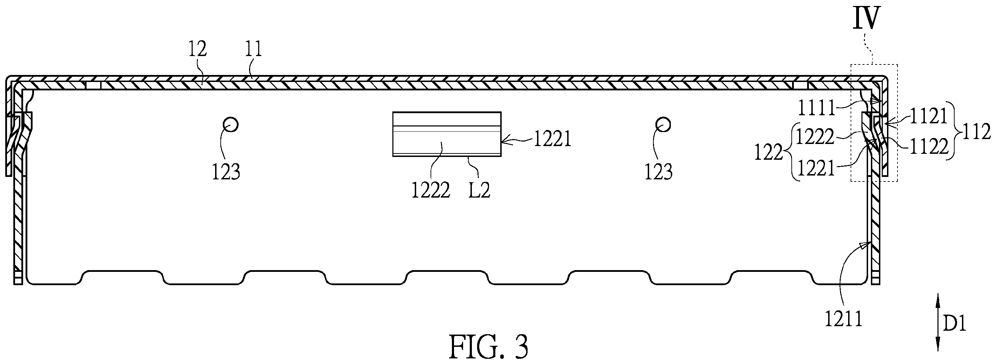

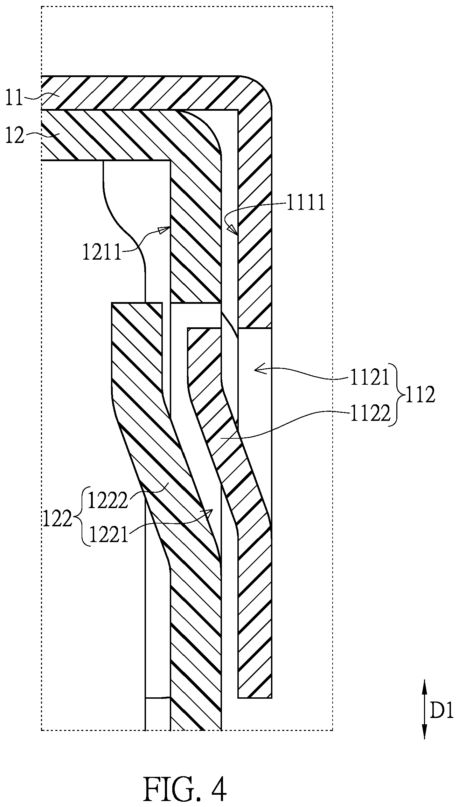

Referring to FIG. 1 to FIG. 4, FIG. 1 is a schematic exploded view of an electromagnetic shielding module according to an embodiment of the present disclosure, FIG. 2 is a schematic view showing an assembled status of the embodiment shown in FIG. 1, FIG. 3 is a schematic cross-sectional view of the embodiment shown in FIG. 2, and FIG. 4 is a partial schematic enlarged view of the embodiment shown in FIG. 3.

An electromagnetic shielding module 1 includes a cover 11 and a frame 12. The cover 11 has a first side wall 111 and a first snap structure 112. The first snap structure 112 is arranged on the first side wall 111. The first snap structure 112 has a first slot 1121 and a first elastic arm 1122. The first elastic arm 1122 is connected to a sideline L1 of the first slot 1121 and extends out of a first inner wall surface 1111 as shown in FIG. 3. The frame 12 can be combined with the cover 11. The frame 12 has a second side wall 121 and a second snap structure 122. The second snap structure 122 is arranged on the second side wall 121. The second snap structure 122 has a second slot 1221 and a second elastic arm 1222. The second elastic arm 1222 is connected to a periphery L2 of the second slot 1221 and extends out of a second inner wall surface 1211. When the cover 11 and the frame 12 are forced to be brought closer to each other until the first snap structure 112 and the second snap structure 122 are combined, the first elastic arm 1122 and the second elastic arm 1222 overlap and engage with each other.

In the embodiment shown in FIG. 1, the sideline L1 is a bottom edge of the first slot 1121, and the periphery L2 is a bottom edge of the second slot 1221. Further, as shown in FIG. 4, the first elastic arm 1122 extends upward along a vertical direction D1, and the second elastic arm 1222 extends upward along the vertical direction D1. However, the present disclosure is not limited thereto. In some embodiments, the sideline L1 is a side edge of the first slot 1121, and the periphery L2 is a side edge of the second slot 1221. The first elastic arm 1122 extends along a horizontal direction, and the second elastic arm 1222 extends along the horizontal direction (not shown in the figures).

According to some embodiments, a top plate 113 of the cover is provided with a through hole, which can be arranged at any position of the top plate 113 (not shown in the figures), and the through hole can be used for air and heat conduction. According to the embodiment shown in FIG. 1, a top wall 124 of the frame 12 is provided with four openings 1241, and the top wall 124 has a bracket in a cross shape. The opening 1241 can be used as a maintenance hole to facilitate a user's maintenance of components covered by the frame 12.

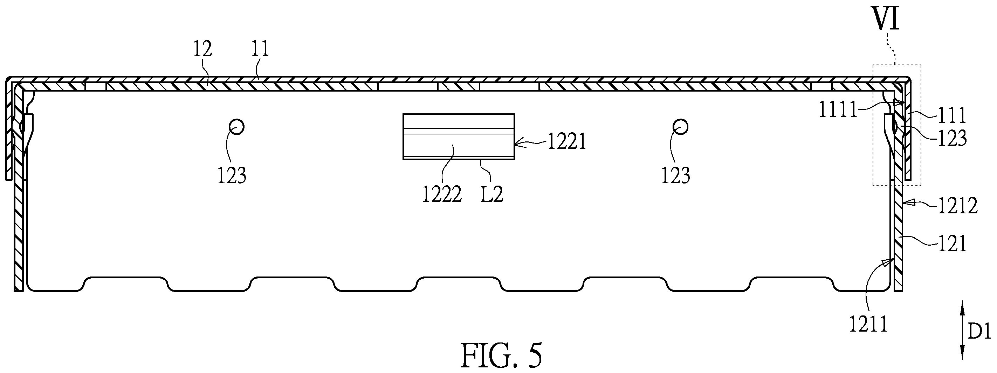

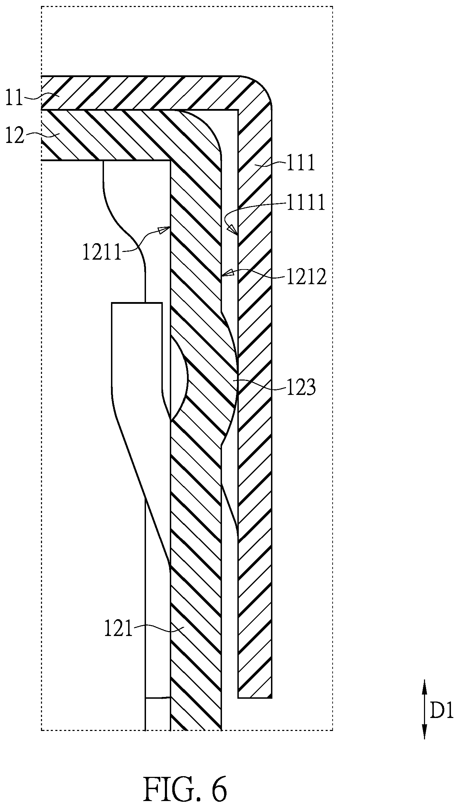

Referring to FIG. 5 and FIG. 6, which are to be read in conjunction with FIG. 2, FIG. 5 is a schematic cross-sectional view of the embodiment shown in FIG. 2, and FIG. 6 is a partial schematic enlarged view of the embodiment shown in FIG. 5. In the embodiment shown in FIG. 2, the frame 12 further has a projection 123 arranged on an outer wall surface 1212 of the second side wall 121. According to the present embodiment, a portion of the second side wall 121 protrudes outward to form the projection 123. When the first snap structure is combined with the second snap structure 122, the projection 123 is abutted against the first inner side wall surface 1111. The projection 123 can be a bump or a ball. By providing the projection 123, a connection strength between the cover 11 and the frame 12 can be enhanced, so as to avoid being easily affected by shaking or vibration.

According to some embodiments, a material of each of the cover 11 and the frame 12 can include, but is not limited to, metal or alloy. For example, each of the cover 11 and the frame 12 is made of pure metal. In some embodiments, each of the cover 11 and the frame 12 is made of tinplate (SPTE), nickel silver, or galvanized steel (SECC). However, the present disclosure is not limited thereto.

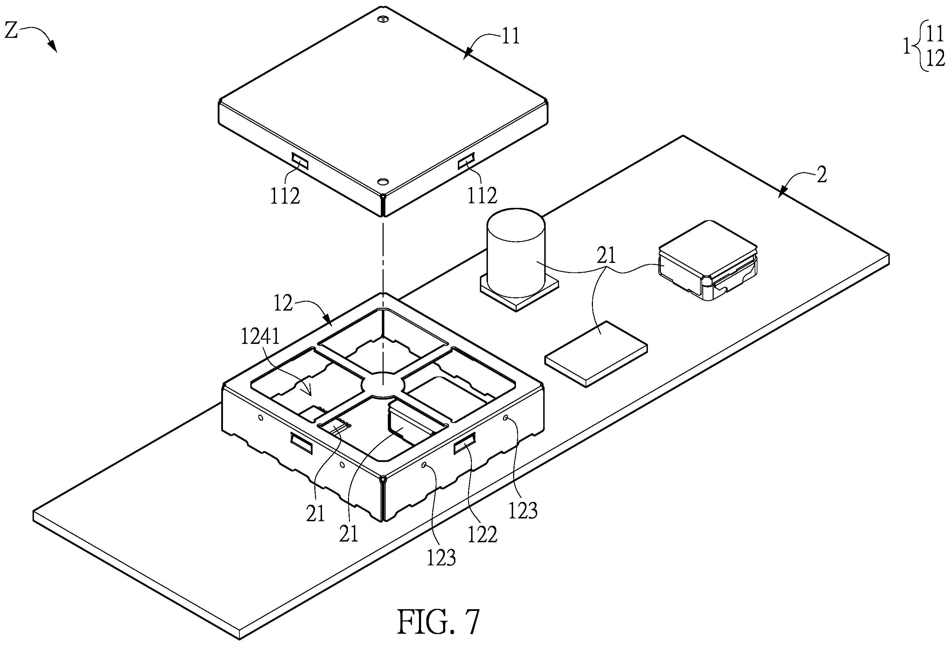

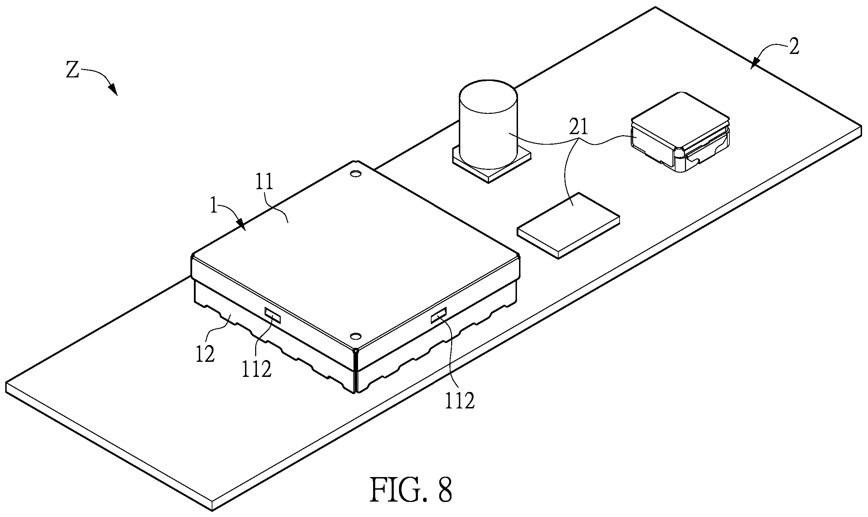

Referring to FIG. 7 and FIG. 8, FIG. 7 is a partial schematic view of a photoelectric device according to an embodiment of the present disclosure, showing that the cover and the frame of the electromagnetic module are separated from each other with the frame being disposed on a circuit board, and FIG. 8 is a schematic view showing an assembled status of the embodiment shown in FIG. 7.

A photoelectric device Z includes a circuit board 2 and the electromagnetic shielding module 1. The circuit board 2 is provided with a plurality of electronic components 21. The electromagnetic shielding module 1 is disposed on the circuit board 2 to cover at least one of the plurality of electronic components 21. The photoelectric device Z can be a vehicle lamp. For example, the vehicle lamp can be a daytime running light, a directional light, a position light, a tail light, a brake light, a reversing light, a rear fog light, or a light driving device, but the present disclosure is not limited thereto. The electronic component 21 is, for example, a capacitor, a power component, a semiconductor chip, and an inductor.

### [Beneficial Effects of the Embodiments]

One of the beneficial effects of the present disclosure is that, the electromagnetic shielding module provided by the present disclosure can be applied to any module that needs to be protected from electromagnetic interference. According to one embodiment of the electromagnetic shielding module and the photoelectric device, by virtue of "the cover having the first side wall and the first snap structure," "the first snap structure having the first slot and the first elastic arm, the first elastic arm being connected to the sideline of the first slot," "the frame having the second side wall and the second snap structure," "the second snap structure having the second slot and the second elastic arm, the second elastic arm being connected to the periphery of the second slot," and "when the cover and the frame are forced to be brought closer to each other until the first snap structure and the second snap structure are combined, the first elastic arm and the second elastic arm overlap and engage with each other," radiation properties, conductivity properties, spectral distribution, interference suppression, compliance with standards, and anti-interference capabilities of electromagnetic interference can be complied. In addition, the structural strength of the electromagnetic shielding module can be enhanced, improving the inadequacies of the existing technology.

Further, in one embodiment, the top plate of the cover is provided with the through hole, and the through hole can be used for air and heat conduction.

Further, in one embodiment, the frame further has the projection. By providing the projection, the connection strength between the cover and the frame can be enhanced, so that the electromagnetic shielding module is not easily disintegrated or loosened due to shaking or vibration.

The foregoing description of the exemplary embodiments of the disclosure has been presented only for the purposes of illustration and description and is not intended to be exhaustive or to limit the disclosure to the precise forms disclosed. Many modifications and variations are possible in light of the above teaching.

The embodiments were chosen and described in order to explain the principles of the disclosure and their practical application so as to enable others skilled in the art to utilize the disclosure and various embodiments and with various modifications as are suited to the particular use contemplated. Alternative embodiments will become apparent to those skilled in the art to which the present disclosure pertains without departing from its spirit and scope.

## Claims

1. An electromagnetic shielding module (1), comprising:
a cover (11) having a first side wall (111) and a first snap structure (112), wherein the first snap structure (112) is arranged on the first side wall (111), the first snap structure (112) has a first slot (1121) and a first elastic arm (1122), and the first elastic arm (1122) is connected to a sideline of the first slot (1121) and extends out of a first inner wall surface (1111) of the first side wall (111); and
a frame (12) configured to be combined with the cover (11), wherein the frame (12) has a second side wall (121) and a second snap structure (122), the second snap structure (122) is arranged on the second side wall (121), the second snap structure (122) has a second slot (1221) and a second elastic arm (1222), and the second elastic arm (1222) is connected to a periphery (L2) of the second slot (1221) and extends out of a second inner wall surface (1211) of the second side wall (121);
wherein, when the cover (11) and the frame (12) are forced to be brought closer to each other until the first snap structure (112) and the second snap structure (122) are combined, the first elastic arm (1122) and the second elastic arm (1222) overlap and engage with each other.

2. The electromagnetic shielding module (1) according to claim 1, wherein the first elastic arm (1122) extends upward along a vertical direction (D1), and the second elastic arm (1222) extends upward along the vertical direction (D1).

3. The electromagnetic shielding module (1) according to claim 1, wherein the frame (12) further has a projection (123) arranged on an outer wall of the second side wall (121); wherein, when the first snap structure (112) is combined with the second snap structure (122), the projection (123) is abutted against the first inner side wall surface (1111).

4. The electromagnetic shielding module (1) according to claim 1, wherein the cover (11) further includes a top plate (113), and the top plate (113) is provided with at least one through hole.

5. The electromagnetic shielding module (1) according to claim 1, wherein the frame (12) further has a top wall (124) connected to a second side wall (121) surface (1211), and the top wall (124) is provided with at least one opening (1241).

6. The electromagnetic shielding module (1) according to claim 1, wherein a material of each of the cover (11) and the frame (12) includes metal or alloy.

7. The electromagnetic shielding module (1) according to claim 1, wherein each of the cover (11) and the frame (12) is made of tinplate, nickel silver, or galvanized steel.

8. A photoelectric device (Z), comprising:
a circuit board (2) provided with a plurality of electronic components (21); and
the electromagnetic shielding module (1) as claimed in any one of claims 1-7, wherein the electromagnetic shielding module (1) is disposed on the circuit board (2) to cover (11) at least one of the plurality of electronic components (21).
